# EUROPÄISCHE PATENTSCHRIFT

(11) **EP 1 665 398 B1**
(45) Veröffentlichungstag und Bekanntmachung des Hinweises auf die Patenterteilung: **02.07.2014**
(21) Anmeldenummer: 03818889.2
(22) Anmeldetag: 26.09.2003
(51) Int. Cl.: H01L 33/20, H01L 33/00

(54) **STRAHLUNGSEMITTIERENDER DÜNNSCHICHT-HALBLEITERCHIP**
RADIATION-EMITTING THIN-FILM SEMICONDUCTOR CHIP
PUCE SEMI-CONDUCTRICE EN COUCHE MINCE EMETTANT UN RAYONNEMENT

(43) Veröffentlichungstag der Anmeldung: 07.06.2006
(73) Patentinhaber: OSRAM Opto Semiconductors GmbH, 93055 Regensburg (DE)
(72) Erfinder: EISERT, Dominik, 93049 Regensburg (DE); HAHN, Berthold, 93155 Hemau (DE); HÄRLE, Volker, 93164 Laaber (DE)
(74) Vertreter: Epping - Hermann - Fischer
(86) Internationale Anmeldenummer: PCT/DE2003/003222
(87) Internationale Veröffentlichungsnummer: WO 2005/041313

(56) Entgegenhaltungen:
- EP-A- 1 271 665
- WO-A1-2004/017430
- WO-A2-01/41225
- DE-A- 10 020 464
- US-A1- 2002 017 652
- US-A1- 2003 141 496

## Beschreibung

Die vorliegende Erfindung betrifft strahlungsemittierende Dünnschicht-Halbleiterchips.

Ein strahlungsemittierender Dünnschicht-Halbleiterchip zeichnet sich bevorzugt durch eines oder mehrere, besonders bevorzugt alle der folgenden charakteristischen Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf;
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Epitaxieschichtenfolge führt, d.h. sie weist ein möglichst ergodisch stochastisches Streuverhalten auf;
- die Epitaxieschichtenfolge wird zunächst auf ein Aufwachssubstrat aufgewachsen, wobei nachfolgend die Epitaxieschichtenfolge von dem Aufwachssusbtrat abgelöst und auf dem Trägerelement befestigt wird.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Ein Dünnfilm-Leuchtdioden-Chip ist in guter Näherung ein Lambert'scher Oberflächenstrahler und eignet sich von daher besonders gut für die Anwendung in einem Scheinwerfer. Herkömmliche strahlungsemittierende Halbleiterchips haben aus fertigungstechnischen Gründen häufig eine rechtwinklige Geometrie. Die Halbleiterchips bestehen im allgemeinen aus einer epitaktisch auf einem Trägersubstrat abgeschiedenen Mehrschichtstruktur mit einer aktiven, strahlungserzeugenden Schicht. Das Trägersubstrat ist vorzugsweise elektrisch leitfähig, um einen vertikalen Stromfluss zu ermöglichen; außerdem ist es in vielen Fällen günstig, wenn das Trägersubstrat für die in der aktiven Schicht der Mehrschichtstruktur erzeugte Strahlung transparent ist. Allerdings steht eine hohe Transparenz häufig in Widerspruch zu einer hohen elektrischen Leitfähigkeit des Materials für das Trägersubstrat. So ist zum Beispiel der für Leuchtdioden auf GaN-Basis verwendete Saphir für blaues Licht transparent, aber nicht elektrisch leitfähig. Siliziumcarbid als Trägersybstrat für GaN-Leuchtdioden ist dagegen zwar leitfähig und transparent, aber die Transparenz nimmt mit zunehmender Leitfähigkeit ab, so dass die Eigenschaften des Halbleiterchips auch in diesem Fall nicht ideal sind.

Im allgemeinen dienen Halbleiterchips auf GaN-Basis vorwiegend der Strahlungserzeugung im blau-grünen Spektralbereich und weisen eine Mehrzahl von Schichten auf, die aus einem GaN-basierenden Material bestehen. Unter einem GaN-basierenden Material werden im Rahmen dieser Erfindung neben GaN selbst auch von GaN abgeleitete oder mit GaN verwandte Materialien sowie darauf aufbauende ternäre oder quaternäre Mischkristalle verstanden. Mit anderen Worten bedeutet "auf GaN-Basis" in diesem Zusammenhang, dass ein derart bezeichnetes Bauelement oder Teil eines Bauelements vorzugsweise AlₙGaₘIn₁₋ₙ₋ₘN enthält, wobei 0 ≤ n ≤ 1, 0 < m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können. Insbesondere zählen hierzu die Materialien GaN, AlN, InN, Al₁₋ₓGaₓN, In₁₋ₓGaₓN, In₁₋ₓAlₓN und Al_{1-x-y}InₓGa_{y}N mit 0 < x < 1, 0 < y < 1 und x + y ≤ 1.

Eine Möglichkeit zur Verringerung der Absorptionsverluste und damit zur Steigerung des externen Wirkungsgrades ist daher das Entfernen des Trägersubstrats in Verbindung mit geeigneten Spiegelschichten (Dünnfilmkonzept). Allerdings ist ein Halbleiterdünnfilm im wesentlichen eine planparallele Platte, deren Auskoppeleffizienz aufgrund der Geometrie gegenüber einer Standarddiode nicht erhöht ist. Insbesondere wenn für den Halbleiterchip bereits ein nur wenig absorbierendes Trägersubstrat (zum Beispiel GaN auf SiC) verwendet wurde, ist die Steigerung des externen Wirkungsgrades des Dünnschicht-Halbleiterchips zu gering, um den erhöhten technischen Aufwand der Entfernung des Trägersubstrats zu rechtfertigen.

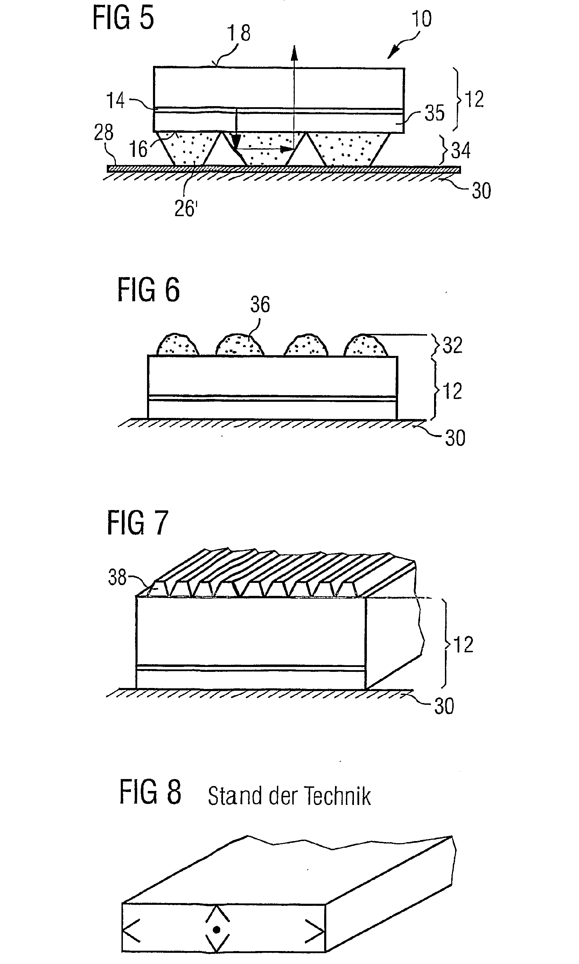

Zur Erläuterung der Problematik der Strahlungsauskopplung zeigt Figur 8 schematisch einen Halbleiterchip mit den Kegeln der Strahlungsauskopplung. Strahlung kann aus dem Halbleiterchip nur aus einem Kegel mit einem Öffnungswinkel von θ = sin⁻¹ (nₑₓₜ/nᵢₙₜ) ausgekoppelt werden, wobei nᵢₙₜ den Brechungsindex des Halbleitermaterials und nₑₓₜ den Brechungsindex der Umgebung bezeichnet. Für einen GaN-Halbleiter (nᵢₙₜ = 2,5) beträgt der Auskoppelwinkel θ gegen Luft (nₑₓₜ = 1) 23° und gegen einen Kunststoffverguss (nₑₓₜ = 1,5) 37°. Im Halbleiterchip erzeugte Strahlung, die nicht innerhalb eines Kegels auf die Grenzflächen trifft, wird schließlich reabsorbiert und in Wärme umgewandelt. Der Auskoppelkegel ist für GaN-Systeme im Vergleich zu GaAs-Systemen (nᵢₙₜ = 3,5) zwar groß, führt aber dennoch zu unerwünscht groβen Strahlungsverlusten.

Diese Verhältnisse ändern sich auch nicht wesentlich bei veränderten Schichtdicken. Allerdings ist für den über die Oberseite ausgekoppelten Strahl die Dünnfilmgeometrie günstig, da aufgrund des kurzen Weges im Halbleiter die Absorption gering ist; für den seitlich ausgekoppelten Strahl kann dagegen die Effizienz aufgrund der Mehrfachreflexionen im Halbleiter sogar geringer sein.

Es gibt deshalb bereits verschiedene Ansätze, den externen Wirkungsgrad von Halbleiterchips durch veränderte Geometrien zu erhöhen. Hier ist insbesondere eine sogenannte Mikrostrukturierung der gesamten Mehrschichtstruktur zu nennen, die aufgrund der größeren Gesamtfläche der Seitenflächen der Mehrschichtstruktur zu einer verstärkten seitlichen Strahlungsauskopplung führt. Zusätzlich können die Seitenflächen der so erzeugten einzelnen Mehrschichtstrukturen angeschrägt werden. Beispiele für derartige Halbleiterchips sind in DE-A-198 07 758, EP-A-0 905 797 oder JP-A-08-288543 offenbart.

Eine weitere Möglichkeit zur Erhöhung der Strahlungsauskopplung ist in den Figuren 3 und 5 der DE-A-199 11 717 gezeigt. Hier sind der Mehrschichtstruktur mit der aktiven, strahlungserzeugenden Schicht einzelne Strahlungsauskoppelelemente in Form von Kugelsegmenten oder Kegelstümpfen zugeordnet, die beispielsweise mittels entsprechendem Ätzen von aufgewachsenen Schichten ausgebildet werden.

Die Druckschrift DE 100 20 646 A1 betrifft ein strahlungsemittierendes Halbleiterbauteil auf der Basis von GaN.

In der Druckschrift US 2003/0141496 A1 findet sich ein optoelektronischer Halbleiterchip auf der Basis von InGaAlP.

Ein Licht emittierendes Halbleiterbauteil ist in der Druckschrift EP 1 271 665 A2 auf der Basis von InGaAlP angegeben.

Die Beschreibung eines strahlungemittierenden Dünnschicht-Halbleiterbauelements auf GaN-Basis ist in der Druckschrift WO 2004/017430 A1 enthalten.

Es ist in der Druckschrift WO 01/41225 A2 offenbart, die Lichtauskoppeleffizienz einer AlInGaN-LED durch optische Elemente zu verbessern.

In die Begriffe des vorliegenden Anspruchs 1 gefasst, offenbart diese Druckschrift in der in Abbildung 6 gezeigten Ausführungsform einen strahlungsemittierenden Dünnschicht-Halbleiterbauchip mit einer epitaktischen Mehrschichtstruktur, die eine aktive, strahlungserzeugende Schicht enthält und eine erste Hauptfläche und eine der ersten Hauptfläche abgewandte zweite Hauptfläche zum Auskoppeln der in der aktiven, strahlungserzeugenden Schicht erzeugten Strahlung aufweist, wobei
- die erste Hauptfläche der Mehrschichtstruktur mit einer reflektierenden Grenzfläche, - an der Grenzfläche zum Substrat-, gekoppelt ist, und zwischen der ersten Hauptfläche der Mehrschichtstruktur und der reflektierenden Grenzfläche eine transparente Schicht vorgesehen ist, welche ein- oder zweidimensional strukturiert ist, und
- die transparente Schicht zwischen der ersten Hauptfläche der Mehrschichtstruktur und der reflektierenden Grenzfläche konvexe Erhebungen aufweist.

Der vorliegenden Erfindung liegt die Aufgabe zugrunde, einen strahlungsemittierenden Dünnschicht-Halbleiterchip bereitzustellen, der einen verbesserten externen Wirkungsgrad der Strahlungsauskopplung aufweist.

Der strahlungsemittierende Dünnschicht-Halbleiterchip gemäß einer Abwandlung der Erfindung weist eine Mehrschichtstruktur auf, die eine aktive, strahlungserzeugende Schicht enthält und eine erste Hauptfläche und eine der ersten Hauptfläche abgewandte zweite Hauptfläche zum Auskoppeln der in der aktiven, strahlungserzeugenden Schicht erzeugten Strahlung aufweist. Bei der Erfindung enthält die Mehrschichtstruktur bevorzugt ein Material auf GaN-Basis. Es können für die Mehrschichtstruktur aber auch andere Verbindungshalbleiter aus dem III-V Halbleitermaterialsystem, wie Phosphid- oder Arsenid-Verbindungshalbleiter (d.h. AlₐGa_{b}In_{1-a-b}P oder AlₐGa_{b}In_{1-ab}As, wobei 0 ≤ a ≤ 1, 0 ≤ b ≤ 1 und a+b ≤ 1), oder aus dem II-VI Halbleitermaterialsystem verwendet werden. Weiterhin ist die erste Hauptfläche der Mehrschichtstruktur mit einer reflektierenden Schicht bzw. Grenzfläche gekoppelt, und der an die zweite Hauptfläche der Mehrschichtstruktur angrenzende Bereich der Mehrschichtstruktur ist ein- oder zweidimensional strukturiert.

Die Erhöhung des externen Wirkungsgrades der Strahlungsauskopplung beruht auf der Brechung der rechtwinkligen Geometrie des Dünnschicht-Halbleiterchips durch eine Strukturierung des Halbleiterdünnfilms selbst. Die Steigerung des Wirkungsgrades wird im Rahmen der nachfolgenden detaillierten Beschreibung mit Hilfe von Untersuchungsergebnissen belegt.

Vorzugsweise weist der an die zweite Hauptfläche der Mehrschichtstruktur angrenzende strukturierte Bereich der Mehrschichtstruktur konvexe Erhebungen in Form von Pyramidenstümpfen, Kegelstümpfen, Kegeln oder Kugelsegmenten (zweidimensionale Strukturierung) bzw. mit einer trapezoiden, dreieckigen oder Kreissegment-Querschnittsform (eindimensionale Strukturierung) auf.

Bei einer Abwandlung liegt der Neigungswinkel der Erhebungen zwischen etwa 30° und etwa 70°, besonders bevorzugt zwischen etwa 40° und etwa 50°. Der Neigungswinkel ist der Winkel, den eine Seitenfläche der Erhebung mit dem Lot zur Haupterstreckungsebene der Mehrschichtstruktur schließt. Außerdem ist die Höhe der Erhebungen wenigstens so groß, vorzugsweise etwa doppelt so groß wie der Abstand zwischen dem strukturierten Bereich und der aktiven, strahlungserzeugenden Schicht. Die Zellengröße einer Erhebung, d. h. die laterale Abmessung einer Erhebung, ist von der Mitte einer Erhebung bis zur Mitte einer benachbarten Erhebung gemessen, wenn die Erhebungen dicht unmittelbar nebeneinander angeordnet sind. Die Zellengröße der Erhebungen wird höchstens etwa fünfmal, vorzugsweise höchstens etwa dreimal so groß wie die Höhe der Erhebungen gewählt.

Die mit der ersten Hauptfläche der Mehrschichtstruktur gekoppelte Schicht bzw. Grenzfläche weist vorteilhafterweise einen Reflexionsgrad von mindestens 70%, besser von mindestens 85% auf.

Die Mehrschichtstruktur kann entweder mit ihrer ersten Hauptfläche direkt oder über eine reflektierende Schicht auf einem Trägersubstrat aufgebracht sein, wobei die reflektierende Schicht bzw. das Trägersubstrat zugleich als elektrische Kontaktschicht des Halbleiterchips dient.

Als Ausgleich für eine begrenzte Querleitfähigkeit der dünnen Halbleiterschicht kann auf der zweiten Hauptfläche der Mehrschichtstruktur eine elektrisch leitfähige, transparente Schicht aufgebracht sein.

Zum Schutz gegen externe Einflüsse kann auf der zweiten Hauptfläche der Mehrschichtstruktur eine transparente Schutz- bzw. Vergütungsschicht aufgebracht sein.

Gemäß der vorliegenden Erfindung wird die Aufgabe durch einen Halbleiterchip mit den Merkmalen von Patentanspruch 1 gelöst. Vorteilhafte Ausgestaltungen und Weiterbildungen dieses Halbleiterchips sind in den abhängigen Ansprüchen definiert.

Dieser strahlungsemittierende Dünnschicht-Halbleiterchip gemäß der Erfindung weist eine Mehrschichtstruktur auf, die eine aktive, strahlungserzeugende Schicht enthält und eine erste Hauptfläche und eine der ersten Hauptfläche abgewandte zweite Hauptfläche zum Auskoppeln der in der aktiven, strahlungserzeugenden Schicht erzeugten Strahlung aufweist. Die erste Hauptfläche der Mehrschichtstruktur ist mit einer reflektierenden Schicht gekoppelt. Es ist zwischen der ersten Hauptfläche der Mehrschichtstruktur und der reflektierenden Schicht eine transparente Schicht vorgesehen, welche ein- oder zweidimensional strukturiert ist.

Die Strukturierung dieser transparenten Schicht zwischen der Mehrschichtstruktur und der reflektierenden Schicht bewirkt, wie die Strukturierung der Mehrschichtstruktur selbst, eine Erhöhung des externen Wirkungsgrads der Strahlungsauskopplung.

Vorzugsweise ist die transparente Schicht leitfähig, um die begrenzte Querleitfähigkeit einer dünnen Mehrschichtstruktur auszugleichen.

Die transparente Schicht zwischen der ersten Hauptfläche der Mehrschichtstruktur und der reflektierenden Schicht weist konvexe Erhebungen vorzugsweise in Form von Pyramidenstümpfen oder Kegelstümpfen (zweidimensionale Strukturierung) bzw. eine trapezoide Querschnittsform (eindimensionale Strukturierung) auf.

In einer bevorzugten Ausführungsform weisen diese Erhebungen einen Neigungswinkel zwischen etwa 30° und etwa 70°, bevorzugt zwischen etwa 40° und etwa 50° auf. Der Neigungswinkel ist der Winkel, den eine Seitenfläche der Erhebung mit dem Lot zur Haupterstreckungsebene der Mehrschichtstruktur schließt. Dabei ist die Höhe der Erhebungen wenigstens so groß, vorzugsweise etwa doppelt so groß wie der Abstand zwischen dem strukturierten Bereich der Mehrschichtstruktur und der aktiven, strahlungserzeugenden Schicht gewählt, und die Zellengröße der Erhebungen beträgt höchstens das Fünffache, vorzugsweise höchstens das Dreifache der Höhe der Erhebungen.

Die mit der ersten Hauptfläche der Mehrschichtstruktur gekoppelte Schicht weist einen Reflexionsgrad von wenigstens 85% auf.

Die reflektierende Schicht kann auf einem Trägersubstrat aufgebracht sein, wobei die reflektierende Schicht zugleich als Kontaktschicht des Halbleiterchips dient.

Die obigen sowie weitere Merkmale und Vorteile der vorliegenden Erfindung werden anhand der folgenden detaillierten Beschreibung verschiedener bevorzugter Ausführungsbeispiele unter Bezugnahme auf die beiliegenden Zeichnungen näher beschrieben. Darin zeigen:
- Figur 1: eine schematische Darstellung einer Abwandlung eines Halbleiterchips im Schnitt;
- Figuren 2a) bis c): schematische Darstellungen zur Erläuterung des optimalen Neigungswinkels der Erhebungen des Halbleiterchips von Figur 1;
- Figuren 3a) bis e): Ergebnisse verschiedener Untersuchungen zur Erläuterung verschiedener optimaler Parameter der Erhebungen des Halbleiterchips von Figur 1;
- Figur 4: eine schematische Darstellung einer Abwandlung des Halbleiterchips von Figur 1;
- Figur 5: eine schematische Darstellung eines Ausführungsbeispiels eines Halbleiterchips gemäß der vorliegenden Erfindung im Schnitt;
- Figur 6: eine schematische Darstellung einer weiteren Abwandlung des Halbleiterchips von Figur 1;
- Figur 7: eine schematische Darstellung einer noch weiteren Abwandlung des Halbleiterchips von Figur 1; und
- Figur 8: eine stark schematisierte Darstellung bezüglich der Strahlungsauskopplung herkömmlicher Halbleiterchips.

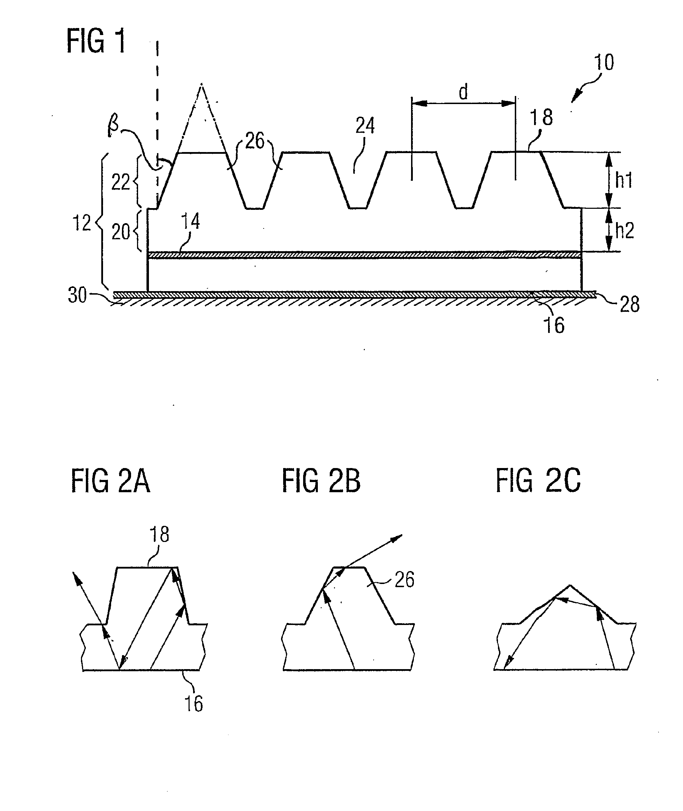

In Figur 1 ist eine Abwandlung eines Dünnschicht-Halbleiterchips dargestellt. Ein Hauptbestandteil des Halbleiterchips 10 ist eine Mehrschichtstruktur 12 bevorzugt auf GaN-Basis, die eine aktive, strahlungserzeugende Schicht 14 enthält. Die Mehrschichtstruktur 12 ist in üblicher Weise epitaktisch gewachsen und enthält hier bekanntermaßen eine Mehrzahl von GaN-basierenden Schichten.

Die Mehrschichtstruktur 12 weist eine erste Hauptfläche 16 und eine der ersten Hauptfläche abgewandte zweite Hauptfläche 18 auf, wobei die in der aktiven, strahlungserzeugenden Schicht 14 erzeugte Strahlung letztlich durch die zweite Hauptfläche 18 aus dem Halbleiterchip 10 ausgekoppelt wird. In der gezeigten Abwandlung ist die aktive Schicht 14 näher an der ersten Hauptfläche 16 als an der zweiten Hauptfläche 18 der Mehrschichtstruktur 12 positioniert. Die in Figur 1 gewählte Position ist allerdings für die nachfolgend beschriebene Strukturierung der Mehrschichtstruktur vorteilhaft, da für die Strukturierung ein dickerer Anteil der Mehrschichtstruktur 12 zur Verfügung steht.

Die Mehrschichtstruktur 12 ist über eine reflektierende Schicht 28, die vorzugsweise aus einem elektrisch leitfähigen Material besteht, auf einem Trägersubstrat 30 zum Beispiel aus Saphir, Si oder SiC aufgebracht. Die reflektierende Schicht 28 kann beispielsweise als metallische Kontaktschicht aus Ag, Al oder einer Ag- oder Al-Legierung oder alternativ als dielektrische Verspiegelung aus mehreren dielektrischen Schichten ausgebildet sein. In einer alternativen Abwandlung kann die Mehrschichtstruktur 12 auch direkt auf dem Trägersubstrat 30 aufgebracht sein, wobei in diesem Fall das Material des Trägersubstrats 30 derart ausgewählt ist, dass die Grenzfläche zwischen Mehrschichtstruktur 12 und Trägersubstrat 30 reflektierend ist.

Der Bereich der Mehrschichtstruktur 12 oberhalb der aktiven Schicht 12 lässt sich, wie deutlich in Figur 1 zu erkennen, im wesentlichen in einen nicht strukturierten Bereich 20, der an die aktive Schicht 14 angrenzt, und einen strukturierten Bereich 22, der an die zweite Hauptfläche 18 angrenzt unterteilen. Die Strukturierung der Mehrschichtstruktur 12 erfolgt beispielsweise mittels üblicher Lithographie- und/oder Ätzverfahren an den epitaktisch aufgewachsenen Halbleiterschichten, durch welche nutartige Ausnehmungen bzw. Vertiefungen 24 ausgebildet werden, zwischen denen entsprechende Erhebungen 26 zurückbleiben.

Die Strukturierung der Mehrschichtstruktur 12 kann entweder eindimensional, d.h. mit Vertiefungen 24 in nur einer Koordinatenrichtung der Ebene der zweiten Hauptfläche 18, oder zweidimensional, d.h. mit Vertiefungen 24 in zwei vorzugsweise senkrecht zueinander verlaufenden Koordinatenrichtungen der Ebene der zweiten Hauptfläche 18, ausgebildet sein. Die zwischen den Vertiefungen 24 entstehenden Erhebungen 26 sind üblicherweise konvex geformt. Dabei sind eindimensionale Strukturierungen beispielsweise mit einer trapezoiden (siehe Figur 1), dreieckigen, Kreissegment- oder Halbkugel-Querschnittsform und zweidimensionale Strukturierungen entsprechend in Form von Pyramidenstümpfen, Kegelstümpfen, Kegeln, Kugelsegmenten oder Halbkugeln ausgebildet.

In Figur 1 sind Erhebungen 26 in Form von Pyramidenstümpfen dargestellt. Wie in Figur 1 gezeigt, schließt eine Seitenfläche der Erhebung 26 einen Neigungswinkel β mit dem Lot zur Haupterstreckungsebene der Mehrschichtstruktur. Diese Definition ist entsprechend auch auf andere Formen der Erhebungen 26 übertragbar. Aufgrund der konvex geformten Erhebungen 26 wird die in der aktiven Schicht 14 erzeugte Strahlung gegebenenfalls mehrfach an den Grenzflächen der Mehrschichtstruktur 12 reflektiert bis die Strahlung schließlich in dem von den Brechungsindizes der Materialien und der Umgebung abhängigen Strahlungsauskopplungskegel auf die zweite Hauptfläche 18 oder den Boden der Vertiefungen 24 trifft und somit auskoppeln kann.

Wie in den Figuren 2a) bis c) veranschaulicht, hängt der Wirkungsgrad der Strahlungsauskopplung von dem Neigungswinkel β der Erhebungen 26 ab. Sehr steile Flanken, wie in Figur 2a) erhöhen die Oberfläche des Bauteils und sind damit für die Strahlungsauskopplung günstig, aber sie sind mit einer Verminderung der Anzahl der aufgrund der Totalreflexion nicht auskoppelbaren Moden bestenfalls nur geringfügig verbunden. Ebenfalls sollten die Flanken der Erhebungen 26 nicht zu flach gewählt sein, wie in Figur 2c) dargestellt, da in diesem Fall die Abweichung von der planparallelen Platte nur gering ist und bis zur Auskopplung eine große Anzahl von Mehrfachreflexionen erfolgen muss, was aufgrund der dabei unvermeidlichen Dämpfung negativ ist.

Am günstigsten ist ein in Figur 2b) dargestellter mittlerer Winkelbereich des Neigungswinkels β der Erhebungen 26. Bei dieser Wahl des Neigungswinkels β kann die Strahlung, die von einer Facette der Erhebung 26 totalreflektiert wird, beim Auftreffen auf die nächste Facette der Erhebung 26 innerhalb des Strahlungsauskopplungskegels ausgekoppelt werden, wodurch auch die Anzahl der Mehrfachreflexionen in der Mehrschichtstruktur gering gehalten wird.

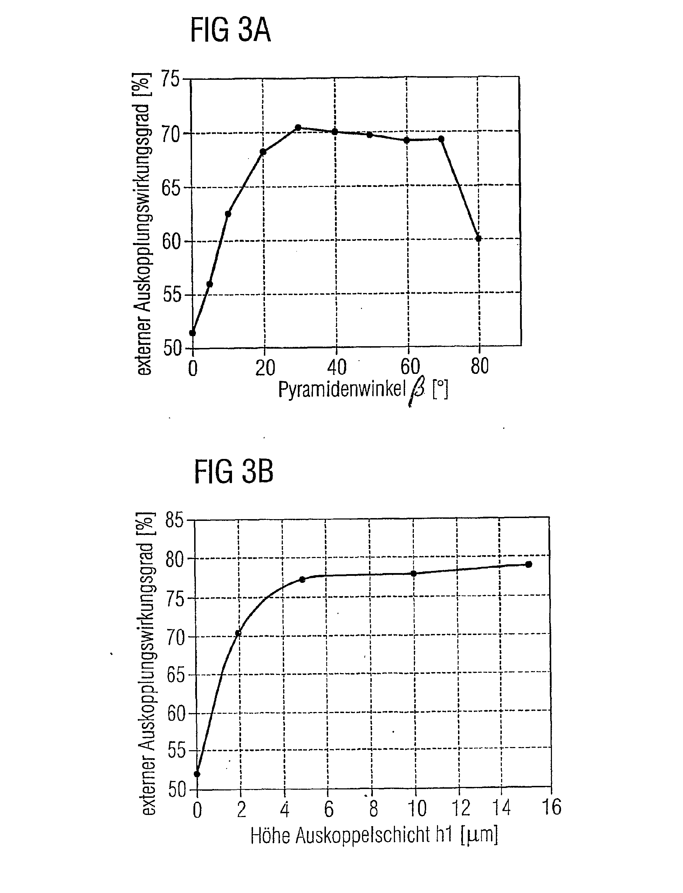

Diese Abschätzung wird auch durch Untersuchungen bestätigt, deren Ergebnisse in Figur 3a) gezeigt sind. Auf der Abszisse ist hierbei der Neigungswinkel β der pyramidenstumpfförmigen Erhebungen 26 aufgetragen, und auf der Ordinate ist der externe Wirkungsgrad der Strahlungsauskopplung aufgetragen. Man erkennt deutlich, dass der beste Wirkungsgrad in einem Bereich des Neigungswinkels β zwischen etwa 30° und etwa 70°, genauer zwischen etwa 40° und etwa 50° erreicht wird. Für Werte des Neigungswinkels β über 70° und unter 30° fällt der Wirkungsgrad der Strahlungsauskopplung deutlich ab. Ein Neigungswinkel β im Bereich um etwa 45° ist somit zu bevorzugen.

Ein weiterer Parameter, der den externen Wirkungsgrad der Strahlungsauskopplung beeinflusst, ist die Höhe h1 der Erhebungen 26. Zur Erzielung eines hohen Wirkungsgrades sollte die Höhe h1 der Erhebungen 26 mindestens so groß wie die Höhe h2 des an die aktive Schicht 14 angrenzenden nicht strukturierten Bereichs 20 gewählt werden. Bevorzugt werden die Erhebungen 26 doppelt so hoch wie der nicht strukturierte Bereich 20 ausgebildet; eine weitere Erhöhung der Erhebungen 26 bringt keine (oder nur geringfügige) weitere Steigerung der Strahlungsauskopplung.

Dies wird durch die in Figur 3b) dargestellten Untersuchungsergebnisse bestätigt. Die Untersuchungsergebnisse zeigen für einen nicht strukturierten Bereich 20 mit einer Höhe h2 von etwa 2 zum den externen Wirkungsgrad der Strahlungsauskopplung über der Höhe h1 der Erhebungen 26. Bei einer Höhe h1 der Erhebungen 26 unterhalb von 2 µm, d.h. kleiner als die Höhe h2 des nicht strukturierten Bereichs 20, erfolgt nur eine ungenügende Strahlungsauskopplung, während bei Höhen h1 der Erhebungen 26 größer als etwa 4 µm keine wesentliche Steigerung des Wirkungsgrades mehr erkennbar ist.

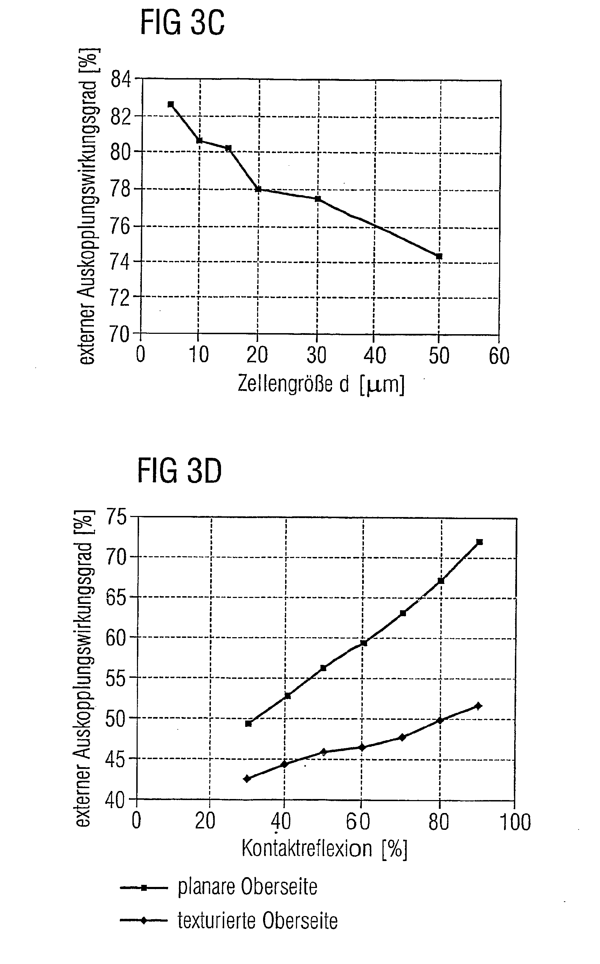

Ferner sind auch Erhebungen 26 mit relativ kleinen lateralen Abmessungen zu bevorzugen. Wie die Untersuchungsergebnisse von Figur 3c) zeigen, ist eine Zellengröße d der Erhebungen von höchstens etwa vier- bis fünfmal der Höhe h1 der Erhebungen 26, vorzugsweise nur von etwa ein- bis dreimal der Höhe h1 der Erhebungen für einen guten Wirkungsgrad vorteilhaft.

Da das Konzept der Dünnschicht-Halbleiterchips u.a. auch auf Mehrfachreflexionen beruht, hat das Reflexionsvermögen der Bauteilrückseite, d.h. der reflektierenden Schicht 28 oder der reflektierenden Grenzfläche ebenfalls einen Einfluss auf den externen Wirkungsgrad des Halbleiterchips. Man erkennt in dem Diagramm von Figur 3d), dass bei einem herkömmlichen planaren Dünnfilm der Wirkungsgrad der Strahlungsauskopplung nur wenig von dem Reflexionsvermögen der rückseitigen Kontaktschicht abhängt (untere Kurve in Figur 3d)). Für eine strukturierte Mehrschichtstruktur 12 wie in Figur 1 hängt der Wirkungsgrad jedoch stark von dem Reflexionsvermögen der reflektierenden Schicht 28 bzw. Grenzfläche ab (obere Kurve in Figur 3d)) und sollte möglichst über 70%, vorzugsweise über 85% gewählt werden.

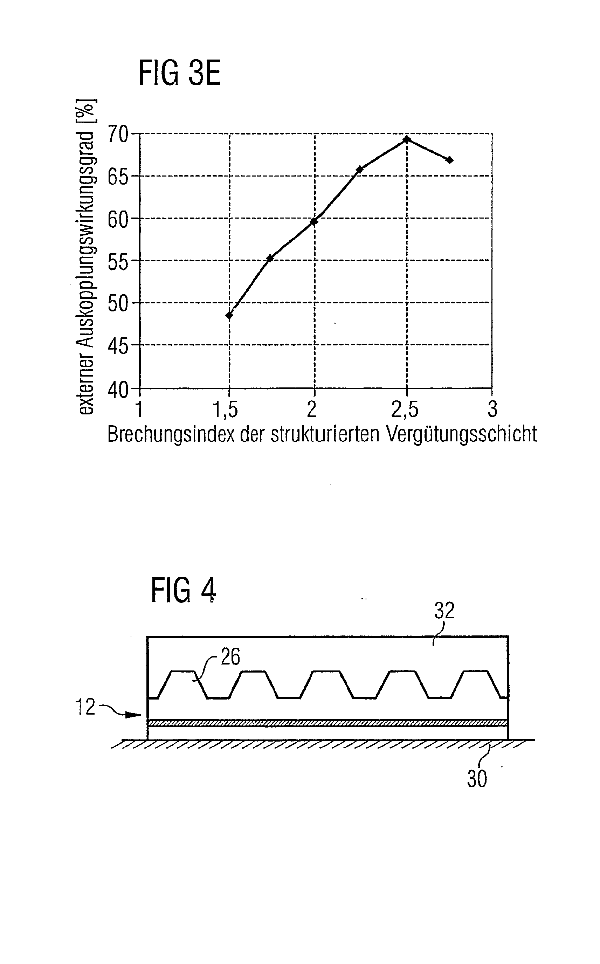

In Figur 4 ist eine Abwandlung des Halbleiterchips von Figur 1 dargestellt. Der Unterschied zwischen den beiden Ausführungsformen besteht darin, dass auf der strukturierten zweiten Hauptfläche 18 der Mehrschichtstruktur 12 eine Schutz- bzw. Vergütungsschicht 32 vorgesehen ist. Diese Schutzschicht 32 soll einerseits den Halbleiter vor externen Einflüssen schützen, andererseits kann die Schutzschicht 32 bei geeigneter Wahl von Brechungsindex und Dicke als Entspiegelungsschicht wirken.

Als weitere Variante des Halbleiterchips aus Figur 1 kann auf der strukturierten zweiten Hauptfläche 18 der Mehrschichtstruktur 12 eine transparente, leitfähige Schicht mit möglichst kleinem Übergangswiderstand zum Halbleiter vorgesehen sein. Durch eine solche transparente, leitfähige Schicht kann man den Nachteil, dass die Strukturierung der Mehrschichtstruktur zur Erhöhung des Wirkungsgrades der Strahlungsauskopplung gleichzeitig eine Verringerung deren Querleitfähigkeit bewirkt, ausgleichen. Es wird eine optimale Stromzuführung zu allen Bereichen des Halbleiterchips erzielt, ohne durch Metallkontakte auf der Mehrschichtstruktur deren Strahlungsauskopplung zu beeinträchtigen.

Die transparente, leitfähige Schicht besteht zum Beispiel aus ZnO, SnO, InO, CdO, GaO oder einer Kombination davon. Diese Materialien zeigen eine n- oder p-Leitfähigkeit und können mittels Sputterverfahren, CVD-Verfahren oder Aufdampfen abgeschieden werden.

Ein Ausführungsbeispiel eines strahlungsemittierenden Halbleiterchips gemäß der Erfindung ist in Figur 5 dargestellt.

Der Dünnschicht-Halbleiterchip 10 weist eine Mehrschichtstruktur 12 mit einer aktiven, strahlungserzeugenden Schicht 14 auf. Im Gegensatz zu dem Halbleiterchip gemäß Figur 1 ist hier aber nicht die zweite Hauptfläche 18 der Mehrschichtstruktur 12, durch welche die in der aktiven Schicht 14 erzeugte Strahlung schließlich ausgekoppelt wird, strukturiert, sondern zwischen der ersten Hauptfläche 16 und der reflektierenden Schicht auf dem Trägersubstrat 30 ist eine transparente Schicht 34 vorgesehen, die zur Steigerung der Strahlungsauskopplung strukturiert ist. Dieser Aufbau ist insbesondere dann vorzuziehen, wenn die den Halbleiter 12 gut kontaktierenden Metalle nicht besonders hoch reflektierend sind und deshalb besser reflektierende Metalle wie Ag verwendet werden sollen, die aufgrund einer hohen Migration den Halbleiter verunreinigen können.

Zum Ausgleich einer geringeren Querleitfähigkeit des Dünnschicht-Halbleiters ist es von Vorteil, die transparente Schicht 34 aus einem leitfähigen Material auszubilden.

Die Strukturierung entspricht im wesentlichen der oben anhand der Figur 1 beschriebenen. Als konvexe Erhebungen 26' kommen hier allerdings in erster Linie solche in Form von Pyramidenstümpfen oder Kegelstümpfen bzw. solche mit trapezoider Querschnittsform in Frage. Die oben anhand er Figur 3 erläuterten Parameter der Strukturierung können auf die Erhebungen 26' dieses Ausführungsbeispiels übertragen werden. Hierbei ist die nicht strukturierte Schicht 35 zwischen der aktiven Schicht 14 der Mehrschichtstruktur 12 und der transparenten Schicht 34 als Bezugsgröße heranzuziehen.

Eine weitere Abwandlung des Halbleiterchips von Figur 1 ist in Figur 6 gezeigt. Bei diesem Halbleiterchip 10 ist nicht die Mehrschichtstruktur 12 selbst strukturiert, sondern eine auf der zweiten Hauptfläche 18 der Mehrschichtstruktur 12 aufgebrachte Vergütungsschicht 32 ist mit entsprechenden konvexen Erhebungen 36 versehen.

Typische Vergütungsschichten 32, zum Beispiel aus SiO₂ oder SiNₓ, haben einen Brechungsindex von unter 2, so dass die strahlung an der Grenzfläche zwischen Halbleiter 12 und Vergütungsschicht 32 teilweise totalreflektiert wird. Wie das Diagramm von Figur 3e) zeigt, nimmt die Effektivität der strukturierten Vergütungsschicht 32 mit zunehmender Abweichung des Brechungsindex von dem des Halbleiters mit 2,5 deutlich ab. Eine strukturierte Vergütungsschicht mit niedrigem Brechungsindex kann aber trotzdem vorteilhaft sein, da auch eine totalreflektierte Welle bis etwa zu einer Tiefe der halben Wellenlänge in das Material mit kleinerem Brechungsindex eindringt, dabei allerdings exponentiell abklingt. Die Höhe der strukturierten Vergütungsschicht sollte deshalb nicht mehr als wenige 100 nm betragen und die lateralen Abmessungen liegen im Bereich von Mikrometern.

Wenn die lateralen Abmessungen der Strukturen 36 der Vergütungsschicht 32 in den Bereich der Wellenlänge der auszukoppelnden Strahlung reduziert werden, wird eine auftreffende Welle an einer solchen Mikrostruktur 36 gestreut, wodurch der Strahl in einen größeren Winkelbereich aufgefächert wird.

Schließlich ist in Figur 7 eine weitere Abwandlung des Halbleiterchips von Figur 1 gezeigt. Auf der in diesem Fall nicht strukturierten Mehrschichtstruktur 12 ist eine transparente, leitfähige Schicht 38 aus zum Beispiel ZnO, SnO, InO, CdO, GaO oder einer Kombination davon aufgebracht. Diese transparente, leitfähige Schicht 38 ist analog zu Figur 1 strukturiert, wobei in Figur 7 eine eindimensionale Strukturierung mit Erhebungen mit einer trapezoiden Querschnittsform dargestellt sind.

Der Übergangswiderstand zwischen der transparenten, leitfähigen Schicht 38 und dem Halbleiter 12 sollte möglichst gering sein. Ist dies nicht der Fall, kann zwischen der Schicht 38 und der Mehrschichtstruktur 12 eine (nicht dargestellte) Metallschicht erforderlich sein, die vorzugsweise sehr dünn und damit semitransparent oder unterbrochen ausgebildet ist.

## Patentansprüche

1. Strahlungsemittierender Dünnschicht-Halbleiterchip mit einer epitaktischen Mehrschichtstruktur (12), die eine aktive, strahlungserzeugende Schicht (14) enthält und eine erste Hauptfläche (16) und eine der ersten Hauptfläche abgewandte zweite Hauptfläche (18) zum Auskoppeln der in der aktiven, strahlungserzeugenden Schicht erzeugten Strahlung aufweist und die auf AlGalnP, AlInGaAs oder auf einem II-VI-Halbleitermaterial basiert,
wobei
- die erste Hauptfläche (16) der Mehrschichtstruktur (12) mit einer reflektierenden Schicht (28), die einen Reflexionsgrad von mindestens 85 % aufweist, gekoppelt ist, und zwischen der ersten Hauptfläche (16) der Mehrschichtstruktur und der reflektierenden Schicht eine transparente Schicht (34) vorgesehen ist, welche ein- oder zweidimensional strukturiert ist und die sich unmittelbar an der reflektierenden Schicht (28) und an der Mehrschichtstruktur (12) befindet, und
- die transparente Schicht (34) zwischen der ersten Hauptfläche (16) der Mehrschichtstruktur (12) und der reflektierenden Schicht (28) konvexe Erhebungen (26') aufweist,
- die Höhe (h1) der Erhebungen (26') wenigstens so groß wie die Höhe (h2) eines nicht strukturierten Bereichs (35) der Mehrschichtstruktur (12) insgesamt ist, der sich zwischen der aktiven, strahlungserzeugenden Schicht (14) und den Erhebungen befindet, wobei der nicht strukturierte Bereich (35) zwischen der aktiven Schicht (14) der Mehrschichtstruktur (12) und der transparenten Schicht (34) als Bezugsgröße für die Höhe (h1) der Erhebungen, die von dem nicht strukturierten Bereich (35) ausgehen, heranzuziehen ist.

2. Halbleiterchip nach Anspruch 1,
**dadurch gekennzeichnet, dass** die transparente Schicht (34) leitfähig ist.

3. Halbleiterchip nach Anspruch 1 oder 2,
**dadurch gekennzeichnet, dass** die Erhebungen (26') die Form von Pyramidenstümpfen oder Kegelstümpfen bzw. eine trapezoide Querschnittsform aufweisen.

4. Halbleiterchip nach einem der Ansprüche 1 bis 3,
**dadurch gekennzeichnet, dass** die Erhebungen (26') einen Neigungswinkel (β) zwischen etwa 30° und etwa 70° aufweisen

5. Halbleiterchip nach Anspruch 4,
**dadurch gekennzeichnet, dass** die Erhebungen (26') einen Neigungswinkel (β) zwischen etwa 40° und etwa 50° aufweisen.

6. Halbleiterchip nach einem der Ansprüche 1 bis 5,
**dadurch gekennzeichnet, dass** die Höhe (h1) der Erhebungen (26') doppelt so groß wie die Höhe (h2) des nicht strukturierten Bereichs (35) der Mehrschichtstruktur zwischen der aktiven, strahlungserzeugenden Schicht und den Erhebungen ist.

7. Halbleiterchip nach einem der Ansprüche 1 bis 6,
**dadurch gekennzeichnet, dass** eine Zellengröße (d) der Erhebungen (26') höchstens fünfmal so groß wie die Höhe (h1) der Erhebungen ist.

8. Halbleiterchip nach Anspruch 7,
**dadurch gekennzeichnet, dass** die Zellengröße (d) der Erhebungen höchstens dreimal so groß wie die Höhe (h1) der Erhebungen ist.

9. Halbleiterchip nach einem der Ansprüche 1 bis 8,
**dadurch gekennzeichnet, dass** die reflektierende Schicht (28) auf einem Trägersubstrat (30) aufgebracht ist.

10. Halbleiterchip nach Anspruch 9,
**dadurch gekennzeichnet, dass** die reflektierende Schicht zugleich als Kontaktschicht des Halbleiterchips dient.

11. Halbleiterchip nach einem der Ansprüche 1 bis 10,
**dadurch gekennzeichnet, dass** auf der zweiten Hauptfläche (18) der Mehrschichtstruktur (12) eine transparente Schutzschicht aufgebracht ist.

## Claims

1. Radiation-emitting thin-film semiconductor chip with an epitaxial multilayer structure (12), which contains an active, radiation-generating layer (14) and has a first main area (16) and a second main area (18) - remote from the first main area - for coupling out radiation generated in the active, radiation-generating layer and which is based on AlGaInP, AlInGaAs or on a II-VI semiconductor material, wherein
- the first main area (16) of the multilayer structure (12) is coupled to a reflective layer (28) having a reflectance of at least 85%, and a transparent layer (34) is provided between the first main area (16) of the multilayer structure and the reflective layer, said transparent layer being patterned one- or two-dimensionally and being situated directly at the reflective layer (28) and at the multilayer structure (12), and
- the transparent layer (34) between the first main area (16) of the multilayer structure (12) and the reflective layer (28) has convex elevations (26'),
- the height (h1) of the elevations (26') is at least as large as the height (h2) of a non-patterned region (35) of the multilayer structure (12) overall, which region is situated between the active, radiation-generating layer (14) and the elevations, wherein the non-patterned region (35) between the active layer (14) of the multilayer structure (12) and the transparent layer (34) should be used as a reference variable for the height (h1) of the elevations which proceed from the non-patterned region (35).

2. Semiconductor chip according to Claim 1,
**characterized in that**
the transparent layer (34) is conductive.

3. Semiconductor chip as claimed in Claim 1 or 2
**characterized in that**
the elevations (26') have the form of truncated pyramids or truncated cones or a trapezoidal cross-sectional form.

4. Semiconductor chip according to one of Claims 1 to 3,
**characterized in that**
the elevations (26') have an inclination angle (P) of between approximately 30° and approximately 70°.

5. Semiconductor chip according to Claim 4,
**characterized in that**
the elevations (26') have an inclination angle (β) of between approximately 40° and approximately 50°.

6. Semiconductor chip according to one of Claims 1 to 5,
**characterized in that**
the height (h1) of the elevations (26') is twice as large as the height (h2) of the non-patterned region (35) of the multilayer structure between the active, radiation-generating layer and the elevations.

7. Semiconductor chip according to one of Claims 1 to 6,
**characterized in that**
a cell size (d) of the elevations (26') is at most five times as large as the height (h1) of the elevations.

8. Semiconductor chip according to Claim 7,
**characterized in that**
the cell size (d) of the elevations is at most three times as large as the height (h1) of the elevations.

9. Semiconductor chip according to one of Claims 1 to 8,
**characterized in that**
the reflective layer (28) is applied on a carrier substrate (30).

10. Semiconductor chip according to Claim 9,
**characterized in that**
the reflective layer simultaneously serves as a contact layer of the semiconductor chip.

11. Semiconductor chip according to one of Claims 1 to 10,
**characterized in that**
a transparent protective layer is applied on the second main area (18) of the multilayer structure (12).

## Revendications

1. Puce en semiconducteur à couche mince émettrice de rayonnement, comprenant une structure multicouche épitaxiale (12) qui contient une couche active (14) génératrice de rayonnement et présente une première surface principale (16) ainsi qu'une deuxième surface principale (18) à l'opposé de la première surface principale pour découpler le rayonnement généré dans la couche active génératrice de rayonnement et qui est à base d'AlGaInP, d'AlInGaAs ou d'un matériau semiconducteur II-VI,
- la première surface principale (16) de la structure multicouche (12) étant couplée avec une couche réfléchissante (28), laquelle présente un degré de réflexion d'au moins 85 %, et une couche transparente (34) étant prévue entre la première surface principale (16) de la structure multicouche et la couche réfléchissante, laquelle est structurée de manière uni-ou bidimensionnelle et se trouve directement sur la couche réfléchissante (28) et sur la structure multicouche (12), et
- la couche transparente (34) présentant des élévations convexes (26') entre la première surface principale (16) de la structure multicouche (12) et la couche réfléchissante (28),
- la hauteur (h1) des élévations (26') étant globalement au moins égale à la hauteur (h2) d'une zone non structurée (35) de la structure multicouche (12), laquelle se trouve entre la couche active (14) génératrice de rayonnement et les élévations, la zone non structurée (35) entre la couche active (14) de la structure multicouche (12) et la couche transparente (34) étant à utiliser comme grandeur de référence pour la hauteur (h1) des élévations qui dépassent de la zone non structurée (35).

2. Puce en semiconducteur selon la revendication 1, **caractérisée en ce que** la couche transparente (34) est conductrice.

3. Puce en semiconducteur selon la revendication 1 ou 2, **caractérisée en ce que** les élévations (26') présentent la forme de pyramides tronquées ou de cônes tronqués ou encore une section transversale de forme trapézoïdale.

4. Puce en semiconducteur selon l'une des revendications 1 à 3, **caractérisée en ce que** les élévations (26') présentent un angle d'inclinaison (ß) entre environ 30° et environ 70°.

5. Puce en semiconducteur selon la revendication 4, **caractérisée en ce que** les élévations (26') présentent un angle d'inclinaison (ß) entre environ 40° et environ 50°.

6. Puce en semiconducteur selon l'une des revendications 1 à 5, **caractérisée en ce que** la hauteur (h1) des élévations (26') est égale au double de la hauteur (h2) de la zone non structurée (35) de la structure multicouche entre la couche active génératrice de rayonnement et les élévations.

7. Puce en semiconducteur selon l'une des revendications 1 à 6, **caractérisée en ce qu'**une taille de cellule (d) des élévations (26') est au maximum égale à cinq fois la hauteur (h1) des élévations.

8. Puce en semiconducteur selon la revendication 7, **caractérisée en ce que** la taille de cellule (d) des élévations est au maximum égale à trois fois la hauteur (h1) des élévations.

9. Puce en semiconducteur selon l'une des revendications 1 à 8, **caractérisée en ce que** la couche réfléchissante (28) est appliquée sur un substrat porteur (30).

10. Puce en semiconducteur selon la revendication 9, **caractérisée en ce que** la couche réfléchissante sert en même temps de couche de contact de la puce en semiconducteur.

11. Puce en semiconducteur selon l'une des revendications 1 à 10, **caractérisée en ce qu'**une couche de protection transparente est appliquée sur la deuxième surface principale (18) de la structure multicouche (12).
